# EUROPÄISCHE PATENTSCHRIFT

(11) **EP 0 692 877 B1**
(45) Veröffentlichungstag und Bekanntmachung des Hinweises auf die Patenterteilung: **03.01.2001**
(21) Anmeldenummer: 95110466.0
(22) Anmeldetag: 05.07.1995
(51) Int. Cl.: H03K 19/0185, H03K 19/003

(54) **Treiberschaltung**
Drive circuit
Circuit de commande

(30) Priorität: 12.07.1994 DE 4424480
(43) Veröffentlichungstag der Anmeldung: 17.01.1996
(73) Patentinhaber: DaimlerChrysler Aerospace Aktiengesellschaft, 81663 München (DE)
(72) Erfinder: Feldle, Heinz-Peter, Dr.-Ing., D-89250 Senden (DE); Ludwig, Michael, Dipl.-Ing., D-89155 Erbach (DE); Reber, Rolf, D-89073 Ulm (DE)
(74) Vertreter: Straub, Bernd

(56) Entgegenhaltungen:
- WO-A-89/06880
- US-A- 3 959 666
- PATENT ABSTRACTS OF JAPAN vol. 11 no. 312 (E-548) [2759] ,12.Oktober 1987 & JP-A-62 104312 (NEC CORP.) 14.Mai 1987,

## Beschreibung

Die Erfindung betrifft eine Treiberschaltung nach dem Oberbegriff des Patentanspruchs 1.

Eine solche Treiberschaltung wird in der Elektronik in vielfältiger Weise verwendet, beispielsweise um das Ausgangssignal eines ersten Gerätes und/oder einer ersten Schaltungsanordnung an mindestens ein benötigtes Eingangssignal eines zweiten Gerätes und/oder einer zweiten Schaltungsanordnung anzupassen.

Die Erfindung betrifft eine Treiberschaltung, mit der insbesondere eine Pegelanpassung möglich ist zwischen Schaltungsanordnungen, die in unterschiedlicher Halbleitertechnologie ausgeführt sind. Diese haben aufgrund ihres Herstellungsprozesses unterschiedliche Schwellwerte, insbesondere bei den aktiven Halbleiterbauelementen.

Es ist nun naheliegend, für eine solche Treiberschaltung eine an sich bekannte Differenzverstärkerstufe zu verwenden. Diese enthält als wesentliche Bauelemente zwei Verstärker, z.B. Transistoren, die im folgenden Eingangs- sowie Referenzverstärker genannt werden. Dabei wird an dem Referenzverstärker ein Schwellwert eingestellt, z.B. mit Hilfe einer Spannungsteilerschaltung. Ein an dem Eingangsverstärker anliegendes Eingangssignal wird nun mit diesem Schwellwert verglichen. In Abhängigkeit davon entsteht an einem Ausgang der Differenzverstärkerstufe ein Ausgangssignal mit vorgebbaren elektrischen Eigenschaften.

Eine solche Treiberschaltung ist zwar in vielfältiger Weise verwendbar, hat aber insbesondere den Nachteil, daß der Schwellwert durch einen kostenintensiven Einstell- und/oder Abgleichvorgang auf einen vorgebbaren Sollwert eingestellt werden muß.

Der Erfindung liegt die Aufgabe zugrunde, eine gattungsgemäße Treiberschaltung anzugeben, mit der ein vorgebbarer Schwellwert in einem weiten Toleranzbereich selbsttätig anpaßbar ist an einen Schwellwert, der durch den verwendeten Herstellungsprozeß der Halbleiterbauelemente vorgegeben ist.

Diese Aufgabe wird gelöst durch die in dem kennzeichnenden Teil des Patentanspruchs 1 angegebenen Merkmale. Vorteilhafte Ausgestaltungen und/oder Weiterbildungen sind den Unteransprüchen entnehmbar.

Ein erster Vorteil der Erfindung besteht darin, daß zumindest die aktiven Halbleiterbauelemente der Treiberschaltung in demselben Herstellungsprozeß herstellbar sind wie die Schaltungsanordnung, auf welche die Treiberschaltung wirkt.

Ein zweiter Vorteil besteht darin, daß die Treiberschaltung in GaAs-Technologie ausführbar ist und als Eingangssignale die Ausgangssignale anderer Technologien, z.B. TTL-Technologie, verarbeiten kann.

Ein dritter Vorteil besteht darin, daß die Treiberschaltung zwei komplementäre Ausgangssignale erzeugt und lediglich eine einzige Spannungsquelle benötigt.

Ein vierter Vorteil besteht darin, daß die Treiberschaltung sowie eine von dieser geschaltete Anordnung, z.B. eine Sende-Empfangsanordnung für aktive Phased-Array-Antennen, denselben Temperaturgang besitzen, so daß die vorhandenen Schwellwerte und/oder Toleranzwerte immer gleichsinnig sind.

Ein fünfter Vorteil besteht darin, daß ansonsten nötige externe Verbindungsleitungen, z.B. Bond-Verbindungen, erheblich verringert werden können, so daß die Zuverlässigkeit der Gesamt-Schaltung erhöht wird und deren Herstellungskosten erheblich gesenkt werden.

Ein sechster Vorteil besteht darin, daß die Treiberschaltung sehr schnelle Schaltvorgänge ermöglicht.

Ein siebter Vorteil besteht darin, daß der von der Treiberschaltung benötigte Strom im wesentlichen unabhängig ist von Schaltvorgängen, so daß ansonsten mögliche, sogenannte Schaltspitzen vermieden werden.

Weitere Vorteile ergeben sich aus der nachfolgenden Beschreibung.

Die Erfindung wird im folgenden anhand eines Ausführungsbeispiels näher erläutert unter Bezugnahme auf eine schematisch dargestellte Figur. Diese zeigt ein Prinzipschaltbild einer Treiberschaltung, die geeignet ist, Schaltsignale, welche der TTL- oder CMOS-Technologie entsprechen, in entsprechende Schaltsignale, welche der GaAs-Technologie entsprechen, umzuwandeln. Dabei entstehen zwei zueinander komplementäre (Ausgangs-)Schaltsignale, die in vorteilhafter Weise beispielsweise zum Schalten von Bausteinen für Sende-Empfangsmodulen für aktive Phased-Array-Antennen (phasengesteuerte Antennen) verwendet werden können.

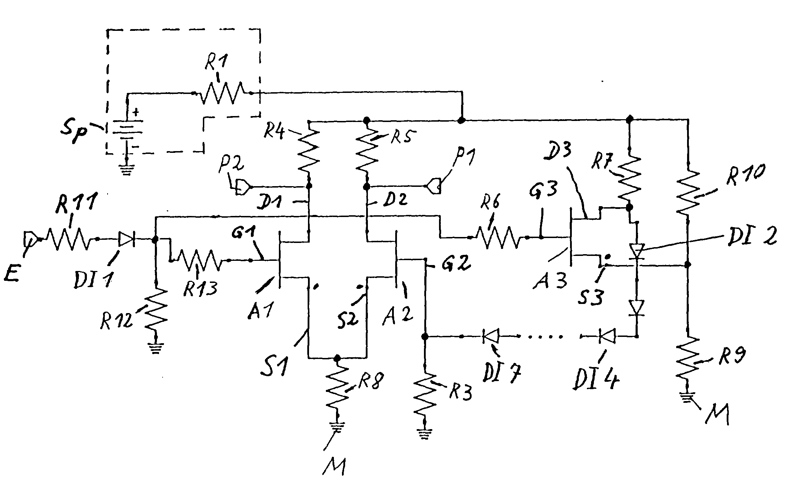

Die in der Figur dargestellten aktiven und passiven Bauelemente sind in derselben Technologie, z.B. monolithischer oder hybrider Technik, hergestellt wie die zu steuernde HF-Schaltung, z.B. Phasenschieber, Schalter, Dämpfungsglieder in dem erwähnten Sende-Empfangsmodul.

Bei der in der Figur exemplarisch dargestellten Treiberschaltung wird angenommen, daß in der durch diese zu steuernden HF-Schaltung in GaAs-Technologie hergestellte Sperrschicht-Feldeffekttransistoren verwendet werden. Diese sind als Schalt-Transistoren ausgebildet, für welche die entsprechenden Schaltspannungen erzeugt werden, was nachfolgend noch näher erläutert wird. Dementsprechend sind die dargestellten Verstärker (Transistoren) A1 bis A3 von demselben Typ, nämlich ebenfalls in GaAs-Technologie hergestellte Sperrschicht-Feldeffekttransistoren für Schaltungsanwendungen, die im folgenden mit FET bezeichnet werden. Die weiteren aktiven Halbleiterbauelemente, die Dioden DI1 bis DI7, sind ebenfalls in GaAs-Technologie hergestellt.

Die dargestellte Differenzverstärkerstufe enthält in an sich bekannter Weise eine Eingangsverstärkerstufe (erster FET A1) sowie eine Referenzverstärkerstufe (zweiter FET A2). Dabei sind die zugehörigen Source-Anschlüsse S1, S2 über einen gemeinsamen ohmschen Source-Widerstand R8 mit dem Bezugspotential (Masse M) verbunden. Die zugehörigen Drainanschlüsse D1, D2 sind einerseits über jeweils einen ohmschen Drainwiderstand R4, R5 mit dem positiven Pol einer Spannungsquelle Sp, welche den Innenwiderstand R1 besitzt, verbunden. Andererseits sind die Drainanschlüsse D1, D2 mit Ausgängen P1, P2 verbunden, an welchen die erzeugten GaAs-(Ausgangs-)Schaltsignale entstehen, die komplementär zueinander sind. Die weitere Verstärkerstufe (dritter FET A3) bewirkt eine Mitkopplung für die Differenzverstärkerstufe. Dieses wird nachfolgend näher erläutert.

Die Spannungsverstärkung in dieser an sich nicht idealen Differenzverstärkerstufe (erster FET A1, zweiter FET A2) reicht nicht aus, um den zweiten FET A2 vollständig in die Sättigung, das heißt, den leitenden Zustand zu treiben. Dadurch würde der erreichbare Spannungspegel an dem Drainanschluß D2 des zweiten FET A2 zu gering sein für eine Ansteuerung zu schaltender Bausteine (Bauelemente), die an den Ausgang P1 angeschlossenen werden können.

Dieser scheinbare Nachteil wird beseitigt durch die Mittkopplung mittels des dritten FET A3. Dieser Transistor verstärkt ein am Eingang E anliegendes Eingangssignal gegenphasig mit einem erhöhten Spannungshub. Der Spannungshub ist so dimensioniert, daß er zum vollständigen Aussteuern des zweiten FET A2 geeignet ist, und zwar bei allen möglicherweise vorkommenden Fertigungstoleranzen. Die am Drainanschluß D3 des dritten FET A3 angeschlossene Diodenkette DI2 bis DI7 bewirkt eine Pegelverschiebung der Ausgangsspannung des dritten FET A3, so daß an dem zweiten FET A2 für dessen Arbeitsbereich geeignete Spannungen entstehen.

Die vollständige Pegelwandlerschaltung ist derart konzipiert, daß deren korrekte Arbeitsweise im wesentlichen von gut reproduzierbaren Widerstandsverhältnissen, die in einer Serienfertigung herstellbar sind, bestimmt wird. Mit Toleranzen behaftete elektrische Transistoreigenschaften können vorteilhafterweise weitgehendst vernachlässigt werden. Zusätzlich sind alle benötigten Spannungshübe sowie Ströme in der Schaltung für den vorkommenden schlechtesten Fall ("worst case") der Transistorparameter ausgelegt.

Soll nun beispielsweise ein logisches zeitabhängiges TTL-Schaltsignal zeitlich hochgenau, d.h. mit einem geringen zeitlichen Toleranzbereich (Jitter), in ein entsprechendes GaAs-Schaltsignal in reproduzierbarer Weise umgesetzt werden, so ist es naheliegend, dafür eine Treiberschaltung mit bezüglich der elektrischen Eigenschaften, insbesondere Verstärkereigenschaften, eng tolerierten Bauelementen, insbesondere Transistoren, zu verwenden. Eine solche Treiberschaltung, insbesondere in GaAs-Technologie zum Ansteuern von GaAs-Sperrschicht-Feldeffekttransistoren, ist jedoch in nachteiliger Weise technisch sehr aufwendig und daher kostenungünstig.

Dieser Nachteil wird bei der Erfindung dadurch vermieden, daß die bei der Treiberschaltung verwendeten Bauelemente, insbesondere die Verstärker (A1 bis A3), von demselben Typ sind wie diejenigen, für welche die Schaltsignale erzeugt werden sollen. Herstellungsbedingte Toleranzen, insbesondere diejenigen der GaAs-Bauelemente, werden bei der Erfindung dadurch berücksichtigt, daß mit Hilfe der Mitkopplung selbsttätig eine von dem Herstellungsprozeß der GaAs-Bauelemente unabhängige Ist-Schaltspannung U_{I} gebildet wird. Diese wird an den Steuereingang G2 des Referenzverstärkers A2 angelegt.

Die Ist-Schaltspannung U_{I} wird erzeugt in Abhängigkeit von dem am Eingang E anliegenden Eingangssignal, z.B. einem TTL-Signal. Diese wird erzeugt mit Hilfe eines zwischen der Spannungsquelle Sp und Masse M vorhandenen U_{S}-Spannungsteilers, welcher aus den ohmschen Widerständen R9, R10 gebildet wird. Die Soll-Schaltspannung U_{S} entsteht an dem Verbindungspunkt der Widerstände R9, R10. An diesen Verbindungspunkt ist der Source-Anschluß S3 des die Mitkopplung bewirkenden weiteren Verstärkers (FET A3) angeschlossen. Dessen Steueranschluß G3 ist über den ohmschen Widerstand R6 an einen Eingangs-Spannungsteiler R11, DI1, R12 für das Eingangssignal angeschlossen. Parallel zu dem U_{S}-Spannungsteiler (R10, R9) liegt ein G2-Spannungsteiler, der aus einer Reihenschaltung des ohmschen Widerstandes R7, mehrerer in Flußrichtung (Durchlaßrichtung) geschalteter Dioden DI2 bis DI7 sowie einem weiteren ohmschen Widerstand R3 besteht. An den weiteren Widerstand R3 ist der Steueranschluß G2 des Referenzverstärkers (FET A2) angeschlossen. An den Verbindungspunkt zwischen dem Widerstand R7 und der Diode DI2 ist außerdem der Drainanschluß D3 des weiteren Verstärkers (FET A3) angeschlossen. Der Steueranschluß G1 des Eingangsverstärkers (FET A1) ist über einen ohmschen Widerstand R13 an den Verbindungspunkt zwischen der Diode DI1 und dem Widerstand R12 des Eingangs-Spannungsteilers angeschlossen. Die dort vorhandene Diode DI1 dient als Verpolschutz für ein am Eingang E anliegendes Eingangssignal, für das daher lediglich positive Spannungswerte zugelassen sind. Die Reihenschaltung der Dioden DI2 bis DI7 dient zum groben stufenweisen Einstellen (in Inkrementen der Durchlaßspannung) der an dem Steueranschluß G2 anliegenden Ist-Schaltspannung.

Bei der beschriebenen Anordnung wurden die Spannungspotentiale für die GaAs-Schaltspannungen durch die Widerstandsverhältnisse der ohmschen Widerstände R5, R8 (für Ausgang P1) sowie R4, R8 (für Ausgang P2) festgelegt. Das Widerstandsverhältnis der ohmschen Widerstände R9, R10 bestimmt die Soll-Schaltspannung für die Differenzverstärkerstufe. Da sich eine herstellungsbedingte Schwankung (Toleranz) der Widerstandsparameter und/oder eine Temperaturänderung auf alle ohmschen Widerstände im gleichen Verhältnis auswirkt, ändern sich die dadurch eingestellten Spannungen vorteilhafterweise allenfalls in einem vernachlässigbaren Maße.

Die verwendeten Verstärker (FET A1 bis A3) sind derart dimensioniert, daß die insbesondere bei der Herstellung von Sperrschicht-Feldeffekt-Transistoren derzeit vorhandenen starken Schwankungen der Transistoreigenschaften die Eigenschaften der Treiberschaltung vorteilhafterweise nahezu nicht beeinflussen. Ein besonders kritischer Parameter ist dabei die Schwellenspannung der Transistoren (A1 bis A3). Mögliche herstellungsbedingte Änderungen (Toleranzen) werden bei der Erfindung dadurch abgefangen, daß die in der Treiberschaltung verwendeten Spannungspotentiale für den schlechtesten Fall ("worst case") ausgelegt sind. Die Schwellenspannung ist somit für alle vorkommenden Werte der Steuerspannungen innerhalb der bekannten Grenzen der möglichen Streuung vorteilhafterweise voll wirksam.

Da die Schwellenspannung vorteilhafterweise lediglich in einem vernachlässigbaren Maße von der Temperatur abhängt, ist bei der Treiberschaltung keine diesbezügliche Kompensation erforderlich.

Durch die beschriebene Schaltungsanordnung ist es möglich, herstellungsbedingte Prozeßstreuungen der Eigenschaften von Widerständen und/oder Transistoren in einem Toleranzbereich von -50 % bis +100% zu kompensieren. Dadurch ist in kostengünstiger Weise eine extrem hohe Ausbeute an funktionsfähigen Treiberschaltungen möglich. Deren Integration zu den anzusteuernden Bauelementen (Phasenschieber, Schalter usw.) verschlechtert die Ausbeute der gesamten Schaltung, z.B. eines Sende-Empfangsmoduls, vorteilhafterweise nicht.

Soll die Treiberschaltung beispielsweise für die erwähnten HF-Bauelemente, z.B. Phasensteller, Schalter usw., die als schaltende Elemente mindestens einen GaAs-Sperrschicht-Feldeffekttransistor besitzen, verwendet werden, so sind dafür beispielsweise zwei zueinander komplementäre positive GaAs-Schaltsignale, die zwischen den Spannungswerten +7,0 V und +3,0 V geschaltet werden können, erforderlich. Es ist vorteilhaft, die für die HF-Bauelemente und die Treiberschaltung erforderlichen Transistoren in demselben Prozeß herzustellen. Dabei wird aber für den dritten FET A3 ein Transistor mit - bezogen auf die Transistoren A1, A2 - geringerer Gateweite verwendet. Dieses ist möglich, da der dritte FET A3 lediglich einen geringeren (Steuer)Strom erzeugen soll. Die GaAs-Schaltsignale sollen weiterhin einem TTL-Signal, das am Eingang E anliegt, entsprechen. Für die beschriebene Treiberschaltung werden daher als Verstärker (A1 bis A3) ebenfalls GaAs-Sperrschicht-Feldeffekttransistoren verwendet. Die Spannungsquelle Sp mit dem Innenwiderstand R1 = 2 Ω erzeugt eine Gleichspannung von +7 V. Die verwendeten ohmschen Widerstände haben folgende Soll-Werte:
R11 = 100 Ω, R12 = 20 kΩ, R13 = 8 kΩ, R4 = R5 = 2,1 kΩ, R8 = 1,3 kΩ, R3 = 15 kΩ, R6 = 8 kΩ, R7 = 4,5 kΩ, R9 = 1,2 kΩ, R10 = 2,7 kΩ.

Für die Dioden DI1 bis DI7 werden GaAs-Dioden mit einer Durchlaßspannung von 0,4 V verwendet. Alternativ dazu ist es möglich, die durch die Dioden DI2 bis DI7 erzeugte Potentialschwelle mit Hilfe eines von einem Konstantstrom durchflossenen Widerstand, z.B. einem zusätzlichen Feldeffekt-Transistor, einzustellen.

Die Erfindung ist nicht auf das beschriebene Ausführungsbeispiel beschränkt, sondern sinngemäß auf weitere anwendbar. Beispielsweise ist es einem Fachmann geläufig, für die Verstärker (A1 bis A3) andere Transistoren, z.B. Feldeffekt-Transistoren auf Silizium-Basis, zu verwenden und mit Hilfe der zugehörigen Parameter die vorhandenen ohmschen Widerstände zu ermitteln.

## Patentansprüche

1. Treiberschaltung mit einer Differenzverstärkerstufe mit mindestens einem Ausgang, an dem ein Schaltsignal auskoppelbar ist, zumindest besteht aus
- einer Eingangsverstärkerstufe mit einem Steuereingang und einem daran angeschlossenen Eingangs-Spannungsteiler zum Anlegen eines Eingangssignales,
- einer Referenzverstärkerstufe mit einem Referenz-Steuereingang und einem daran angeschlossenen Referenz-Spannungsteiler zum Erzeugen eines Referenzsignales für eine Schaltschwelle,
dadurch gekennzeichnet,
- daß an den Referenz-Spannungsteiler (R7, DI2 bis DI7, R3) und den Eingangs-Spannungsteiler (R11, DI1, R12) eine Mitkoppelschaltung angeschlossen ist zur Änderung des Referenzsignales in Abhängigkeit von dem Eingangssignal,
- daß die Mitkoppelschaltung zumindest einen Verstärker (A3) enthält, dessen Steuereingang (G3) über einen Eingangswiderstand (R6) an den Eingangsspannungsteiler angeschlossen ist,
- daß ein Anschluß (D3) des Verstärkers (A3) über einen Widerstand (R7) des Referenz-Spannungsteilers an eine Spannungsquelle (Sp) angeschlossen ist,
- daß ein weiterer Anschluß (S3) des Verstärkers (A3) an den Mittenabgriff eines aus den ohmschen Widerständen bestehenden Soll-Spannungsteilers (R9, R10) angeschlossen ist und
- daß der Soll-Spannungsteiler (R9, R10) an die Spannungsquelle (Sp) sowie das zugehörige Bezugspotential (M) angeschlossen ist.

2. Treiberschaltung nach Anspruch 1, dadurch gekennzeichnet, daß der Eingangsverstärker (A1), der Referenzverstärker (A2) sowie der in der Mitkopplungsschaltung enthaltene Verstärker (A3) jeweils einen Feldeffekttransistor aus demselben Herstellungsprozeß enthalten.

3. Treiberschaltung nach Anspruch 1 oder Anspruch 2, dadurch gekennzeichnet, daß die Feldeffekt-Transistoren als GaAs-Sperrschicht-Feldeffekttransistoren ausgebildet sind.

4. Treiberschaltung nach einem der vorhergehenden Ansprüche, dadurch gekennzeichnet, daß der Referenz-Spannungsteiler (R7, DI2 bis DI7) mindestens ein Halbleiterbauelement (DI2 bis DI7) zur Einstellung eines vorgebbaren Potentialsprungs enthält.

5. Treiberschaltung nach einem der vorhergehenden Ansprüche, dadurch gekennzeichnet, daß mindestens ein Halbleiterbauelement (DI2 bis DI7) als eine in Durchlaßrichtung geschaltete Halbleiterdiode ausgebildet ist.

6. Treiberschaltung nach einem der vorhergehenden Ansprüche, dadurch gekennzeichnet, daß die Feldeffekttransistoren aus demselben Herstellungsprozeß stammen wie diejenigen, welche von mindestens einem der Ausgangssignale, die an den Ausgängen (P1, P2) entstehen, zu schalten sind.

7. Treiberschaltung nach einem der vorhergehenden Ansprüche zur Verwendung auf einer monolithischen oder hybriden Schaltungsanordnung zum Schalten von Hochfrequenz-Bauelementen.

8. Treiberschaltung nach einem der vorhergehenden Ansprüche zur Verwendung in einem Sende-Empfangsmodul einer phasengesteuerten Antenne zum Schalten von Hochfrequenz-Bauelementen auf Gallium-Arsenid (GaAs)-Basis.

## Claims

1. Driver circuit with a sum-and-difference amplifier stage with at least one output at which a switching signal can be decoupled, consisting at least of
- an input amplifier stage with a control input and an input voltage divider, which is connected therewith, for application of an input signal,
- a reference amplifier stage with a reference control input and a reference voltage divider, which is connected therewith, for generation of a reference signal for a switching threshold,
characterised in that
- a positive feedback circuit for varying the reference signal in dependence on the input signal is connected with the reference voltage divider (R7, DI2 to DI7, R3) and the input voltage divider (R11, DI1, RI2),
- the positive feedback circuit comprises at least one amplifier (A3), the control input (G3) of which is connected by way of an input resistance (R6) with the input voltage divider,
- a terminal (D3) of the amplifier (A3) is connected with a voltage source (Sp) by way of a resistance (R7) of the reference voltage divider,
- a further terminal (A3) of the amplifier (A3) is connected with the centre tap of a target voltage divider (R9, R10) consisting of the resistive impedances and
- the target voltage divider (R9, R10) is connected with the voltage source (Sp) as well as the associated reference potential (M).

2. Driver circuit according to claim 1, characterised in that the input amplifier (A1), the reference amplifier (A2) as well as the amplifier (A3) contained in the positive feedback circuit each comprise a field effect transistor from the same manufacturing process.

3. Driver circuit according to claim 1 or 2, characterised in that the field effect transistors are constructed as GaAs blocking layer field effect transistors.

4. Driver circuit according to one of the preceding claims, characterised in that the reference voltage divider (R7, DI2 to DI7) comprises at least one semiconductor component (DI2 to DI7) for setting a predeterminable step in potential.

5. Driver circuit according to one of the preceding claims, characterised in that at least one semiconductor component (DI2 to DI7) is constructed as a semiconductor diode switched in conducting direction.

6. Driver circuit according to one of the preceding claims, characterised in that the field effect transistors originate from the same manufacturing process as those which are to be switched by at least one of the output signals which arise at the outputs (P1, P2).

7. Driver circuit according to one of the preceding claims for use on a monolithic or hybrid circuit arrangement for the switching and high-frequency components.

8. Driver circuit according to one of the preceding claims for use in a transmitter-receiver module of a phase-controlled antenna for switching of high-frequency components based on gallium-arsenide (GaAs).

## Revendications

1. Circuit de commande comprenant un étage amplificateur différentiel comportant au moins une sortie, sur laquelle peut être délivré un signal de commutation, constituée au moins par
- un étage amplificateur d'entrée comportant une entrée de commande et un diviseur de tension d'entrée raccordé à cette entrée pour appliquer un signal d'entrée,
- un étage amplificateur de référence comportant une entrée de commande de référence et un diviseur de tension de référence raccordé à cette entrée pour produire un signal de référence pour un seuil de commutation,
caractérisé en ce
- qu'au diviseur de tension de référence (R7, DI2 à DI7, R3) et au diviseur de tension d'entrée (R11, DI1, R12) est raccordé un circuit de rétroaction positive, pour modifier le signal de référence en fonction du signal d'entrée,
- que le circuit de rétroaction contient au moins un amplificateur (A3), dont l'entrée de commande (G3) est raccordée au diviseur de la tension d'entrée par l'intermédiaire d'une résistance d'entrée (R6),
- qu'une borne (D3) de l'amplificateur (A3) est raccordée par l'intermédiaire d'une résistance (R7) du diviseur de tension de référence, à une source de tension (Sp), et
- qu'une autre borne (S3) de l'amplificateur (A3) est raccordée à la prise médiane d'un diviseur de tension de consigne (R9,R10) constitué par des résistances ohmiques, et
- que le diviseur de tension de consigne (R9,R10) est raccordé à la source de tension (Sp) ainsi qu'au potentiel de référence associé (M).

2. Circuit de commande selon la revendication 1, caractérisé en ce que l'amplificateur d'entrée (A1), l'amplificateur de référence (A2) ainsi que l'amplificateur (A3) contenu dans le circuit de rétroaction positive contiennent chacun un transistor à effet de champ réalisé selon le même procédé de fabrication.

3. Circuit de commande selon la revendication 1 ou la revendication 2, caractérisé en ce que les transistors à effet de champ sont agencés sous la forme de transistors à effet de champ à couches de blocage en GaAs.

4. Circuit de commande selon l'une des revendications précédentes, caractérisé en ce que le diviseur de tension de référence (R7, DI2 à DI7) contient au moins un composant à semiconducteurs (DI2 à DI7) servant à régler un saut de potentiel pouvant être prédéterminé.

5. Circuit de commande selon l'une des revendications précédentes, caractérisé en ce qu'au moins un composant à semiconducteurs (DI2 à DI7) est agencé sous la forme d'une diode à semiconducteurs branchée dans le sens passant.

6. Circuit de commande selon l'une des revendications précédentes, caractérisé en ce que les transistors à effet de champ sont formés avec le même procédé de fabrication que pour les transistors à effet de champ qui doivent être commutés par l'intermédiaire d'au moins l'un des signaux de sortie qui apparaissent sur les sorties (P1,P2).

7. Circuit de commande selon l'une des revendications précédentes, destiné à être utilisé dans un montage monolithique ou hybride pour la commutation de composants à haute fréquence.

8. Circuit de commande selon l'une des revendications précédentes, destiné à être utilisé dans un module d'émission-réception d'une antenne dont la phase est commandée, pour la commutation de composants à haute fréquence à base d'arséniure de gallium (GaAs).
